# EUROPÄISCHE PATENTSCHRIFT

(11) **EP 0 641 070 B1**
(45) Veröffentlichungstag und Bekanntmachung des Hinweises auf die Patenterteilung: **03.02.1999**
(21) Anmeldenummer: 94105948.7
(22) Anmeldetag: 18.04.1994
(51) Int. Cl.: H03G 3/32

(54) **Verfahren und Einrichtung zum Anpassen der Lautstärke eines mobilen Wiedergabegerätes an das Umgebungsgeräusch**
Method and circuit for the adjustment of the level of sound sources in accordance with the ambient noise level
Méthode et dispositif de commande du volume sonore en fonction du niveau de bruit ambiant

(30) Priorität: 27.08.1993 DE 4328798
(43) Veröffentlichungstag der Anmeldung: 01.03.1995
(73) Patentinhaber: Blaupunkt-Werke GmbH, D-31139 Hildesheim (DE)
(72) Erfinder: Becker, Raimund, D-31135 Hildesheim (DE)

(56) Entgegenhaltungen:
- EP-A- 0 141 129
- FR-A- 2 370 376
- IEEE TRANSACTIONS ON CONSUMER ELECTRONICS, Bd.CE-27, Nr.3, August 1981, NEW YORK US Seiten 227 - 233 T. TANIYAMA 'Automatic loudness adjusting circuits for automotive audio systems.'

## Beschreibung

Die Erfindung betrifft ein Verfahren zur Anpassung der Lautstärke eines mobilen Wiedergabegerätes an das Umgebungsgeräusch nach dem Oberbegriff des Anspruchs 1. Ein derartiges Verfahren wird in der Patentanmeldung EP-A-0 141 129 beschrieben.

Mit einem derartigen Verfahren wird die Lautstärke entsprechend dem Geräuschpegel in der Umgebung des Lautsprechers so eingestellt, daß der Wiedergabepegel des Lautsprechers, also der Nutzsignalpegel, immer um einige Dezibel (dB) höher liegt als der Störgeräuschpegel, so daß das vom Lautsprecher abgestrahlte Nutzsignal von dem Hörenden, unabhängig von dem jeweiligen Grad der Umweltgeräusche, in etwa immer gleich laut empfunden wird. Insbesondere für den mobilen Betrieb des Lautsprechers bzw. des Rundfunkempfängers bedeutet das eine wesentliche Verbesserung des Komforts, da vermieden wird, daß der Hörende bei häufig wechselndem Geräuschpegel ständig die Lautstärke nachzustellen gezwungen ist.

Der zur Anpassung der Lautstärke verwendete Regelkreis hat das Bestreben, ständig die Differenz zwischen dem NF- und dem Geräuschpegel zu minimieren. Bei eingeschwungener Regelung ist die Differenz minimal. Tritt jedoch beispielsweise im NF-Signal eine Pause bei gleichbleibendem Geräuschpegel auf, so nimmt die einer Pegelvergleichsschaltung entnommene Steuerspannung für den Regelkreis plötzlich einen hohen Wert an, der den Verstärkungsfaktor des Stellgliedes heraufsetzt bzw. die Durchgangsdämpfung des Stellgliedes herabsetzt. Wird nun die Pause schlagartig mit einem lauten NF-Einsatz beendet, so ist die Lautstärke kurzzeitig zu hoch; es tritt eine in der Wiedergabe als unangenehm empfundene Regelbewegung auf. Unter Pause ist hierbei ein Zeitabschnitt mit verschwindendem NF-Signalpegel gemeint, z. B. bei einem Sprachsignal eine Pause zwischen zwei Worten. Um die durch Pausen hervorgerufenen Störeffekte zu beheben, müssen die Pausen als solche erkannt werden. Bei der Ermittlung einer Pause mittels eines Schwellwertes ist es wenig sinnvoll, einen festen Schwellwert zu definieren, der für die größten auftretenden Störpegel noch ausreichend bemessen ist, da in diesem Fall bei der Wahl einer kaum gestörten NF-Quelle (z. B. CD) schwache NF-Passagen, die noch anhebungswürdig sind, unter diesen Schwellwert fallen. Bei einem für störarme NF-Quellen optimierten niedrigen festen Schwellwert kann hingegen bei qualitativ schlechteren NF-Quellen Rauschen als Nutzsignal gewertet und angehoben werden.

Der Erfindung liegt die Aufgabe zugrunde, ein Verfahren zur Anpassung der Lautstärke eines Autoradios an das Umgebungsgeräusch anzugeben, mit dem NF-Pausen sicher erkannt und durch diese bedingte Lautstärkensprünge weitgehend vermieden werden.

Diese Aufgabe wird erfindungsgemäß durch die im kennzeichnenden Teil des Anspruchs 1 angegebenen Maßnahmen gelöst.

Die mit der Erfindung erzielten Vorteile bestehen insbesondere darin, daß gemäß dem Verfahren NF-Signalpausen auch bei variierendem Störpegel sicher erkannt und somit als störend empfundene NF-Pegelsprünge weitgehend verhindert werden können.

Weitere vorteilhafte Ausgestaltungen der Erfindung sind in den Unteransprüchen angegeben. Mit den in den Ansprüchen 2 und 3 angegebenen Maßnahmen wird bei einer relativ langen Pause der NF-Pegel spürbar abgesenkt. Dieses ist sinnvoll, da der Einsatzpegel der NF am Pausenende um so verschiedener - also auch lauter - vom NF-Pegel am Pausenanfang sein kann, je länger die Pause dauert. Bei einer relativ kurzen Pause ist der Unterschied hingegen an den Pausengrenzen mit großer Wahrscheinlichkeit klein, so daß keine größere Absenkung als Vorsichtsmaßnahme erforderlich ist. Mit den im Anspruch 4 angegebenen Maßnahmen läßt sich in vorteilhafter Weise die Pausenerkennung zusätzlich stabilisieren.

Die Erfindung wird im folgenden anhand von ein Ausführungsbeispiel darstellenden Zeichnungen näher erläutert.

Es zeigen:
- Fig. 1: Ein prinzipielles Blockschaltbild einer Einrichtung zur Anpassung der Lautstärke,
- Fig. 2: ein Diagramm, welches den zeitlichen Ablauf von NF-Hüllkurvensignal und Integratorausgangssignal im Bereich einer gewerteten Signalpause darstellt und
- Fig. 3: ein prinzipielles erweitertes Blockschaltbild einer Einrichtung, bei der einer Pegelvergleichsstufe eine Offset-Spannung zugeführt wird.

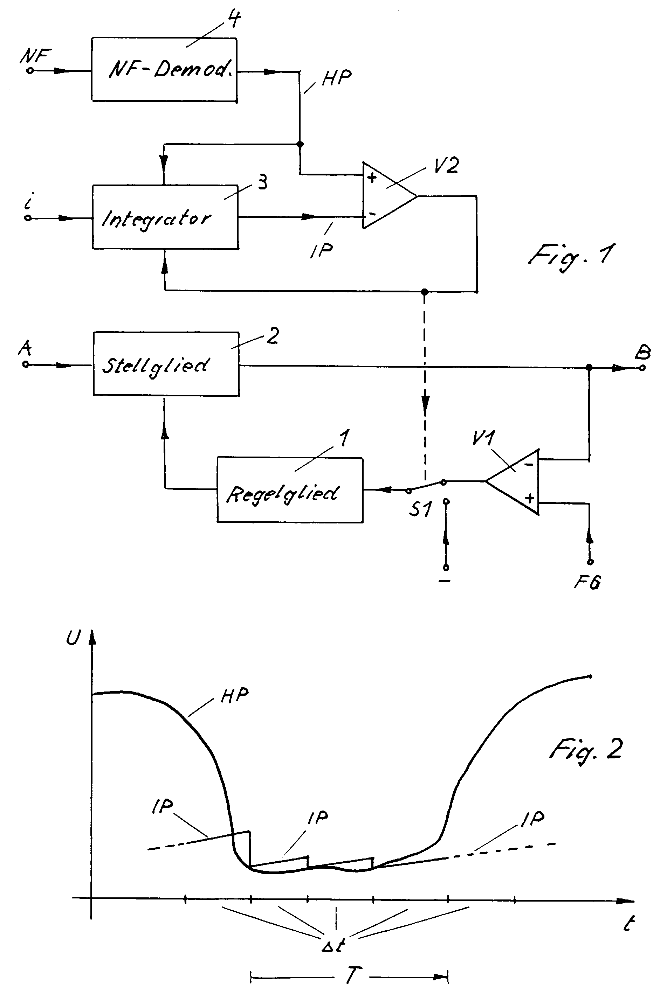

Im NF-Signalweg A-B eines nicht dargestellten Autoradios ist nach Fig. 1 ein über ein Regelglied 1 ansteuerbares Stellglied 2 vorgesehen. Der Eingang des als I-Regler ausgebildeten Regelgliedes 1 ist über einen ersten elektronischen Umschalter S1 in dessen erster Schaltstellung mit dem Ausgang eines als erste Pegelvergleichsstufe betriebenen Operationsverstärkers V1 verbunden, dessen invertierender Eingang mit dem Ausgang des Stellgliedes 2 verbunden ist. Dem nichtinvertierenden Eingang wird das in an sich bekannter Weise ermittelte Fahrgeräuschsignal FG zugeführt. In seiner zweiten Schaltstellung führt der elektronische Umschalter S1 dem Eingang des Regelgliedes 1 eine negative Spannungskonstante zu. Der Ausgang eines als zweite Pegelvergleichsstufe betriebenen Operationsverstärkers V2 ist mit dem Steuereingang des elektronischen Umschalters S1 sowie mit einem ersten Rücksetz-Eingang eines Integrators 3 verbunden. Der Ausgang des Integrators 3 ist mit dem invertierenden Eingang des Operationsverstärkers V2 verbunden, dessen nichtinvertierender Eingang mit dem Ausgang eines NF-Hüllkurvendemodulators 4 verbunden ist. Der Ausgang des Hüllkurvendemodulators 4 ist zudem mit einem zweiten Rücksetzeingang des Integrators 3 verbunden. Dem Eingang des Integrators 3 werden in einem nicht dargestellten Impulsgenerator erzeugte Impulse i zugeführt. Die erste Pegelvergleichsstufe V1 bildet in an sich bekannter Weise zusammen mit dem Regelglied 1 und dem Stellglied 2 einen Regelkreis, der bestrebt ist, in der ersten Schaltstellung von S1 die Differenz zwischen dem NF-Signalpegel und dem Fahrgeräuschpegel zu minimieren.

Zur Erkennung von Signalpausen oder diesen gleichzusetzenden leisen Musikpassagen wird ein dem NF-Signalweg A-B entnommenes Signal dem NF-Hüllkurvendemodulator 4, der einen Zweiweggleichrichter und eine Anordnung zur Signalglättung aufweist, zugeführt. Wie aus der Figur 2 zu ersehen ist, steigt der Integrator-Ausgangspegel IP, solange er kleiner als der NF-Hüllkurvenpegel HP ist, ständig an. Die beiden Pegel IP und HP werden in beliebig vorgebbaren Zeitabständen Δt miteinander verglichen. Wird zum Zeitpunkt einer Abfrage IP größer HP, so wird im Integrator 3 der Pegel IP auf den Wert des Pegels HP zurückgesetzt und der erste Umschalter S1 in die zweite Schaltstellung gebracht. Der Pegel IP steigt nun wieder bis zur nächsten Abfrage an. Solange IP größer HP ist, wird das Ausgangssignal von V2 negativ und der Pegel von IP bei der Abfrage auf den Pegel von HP zurückgesetzt. Bei IP kleiner HP wird der Pegelanstieg von IP ständig fortgesetzt, wobei das Ausgangssignal von V2 positiv ist. Ein negatives Ausgangssignal von V2 wird nun als Pause gewertet. Während der so gewerteten Pause wird die Regelschleife mittels des Umschalters S1 unterbrochen und das Regelglied von der negativen Spannungskonstante derart angesteuert, daß das Stellglied den Pegel des NF-Signals langsam absenkt. Mit dem Ende der Pause wird der Regelkreis wieder aktiviert. Es ist jedoch auch ohne weiteres möglich, den NF-Pegel während einer Pause nicht abzusenken, sondern ihn auch anderweitig zu beeinflussen sowie ihn konstant zu halten.

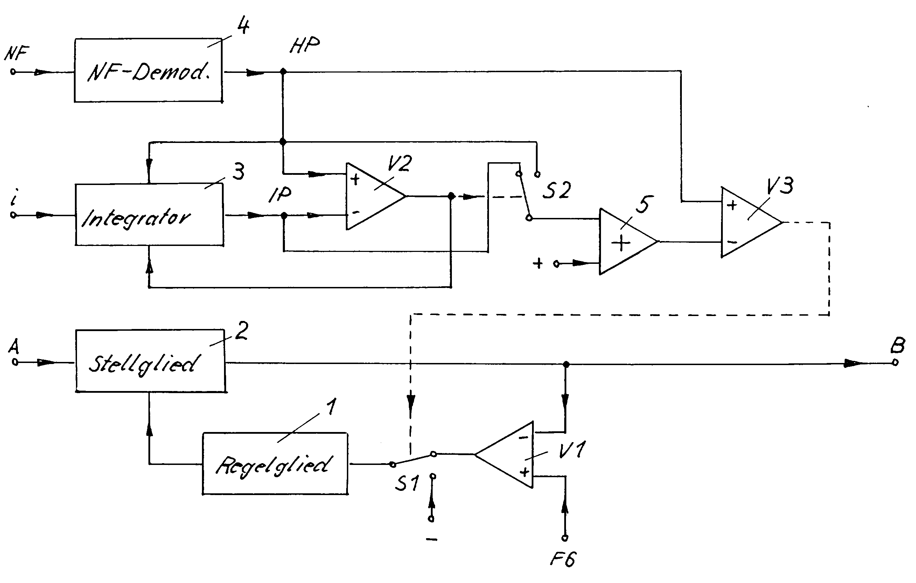

Mit einer Erweiterung der Einrichtung nach Fig. 3 läßt sich mittels eines Addiergliedes 5 eine Offset-Spannung in die Pausenerkennungsschaltung einspeisen. Die Ansteuerung des ersten Umschalters S1 erfolgt hierbei vom Ausgang eines als dritte Pegelvergleichsstufe betriebenen Operationsverstärkers V3, dessen nichtinvertierender Eingang mit dem Ausgang des Hüllkurvendemodulators 4 und dessen invertierender Eingang mit dem Ausgang des Addiergliedes 5 verbunden ist. Ein vom Ausgang der zweiten Pegelvergleichsstufe V2 gesteuerter zweiter elektronischer Umschalter S2 verbindet einen Eingang des Addiergliedes 5 in einer ersten Schaltstellung mit dem Ausgang des Integrators 3 und in einer zweiten Schaltstellung mit dem Ausgang des Hüllkurvendemodulators 4. Durch diese Maßnahme werden während einer von der zweiten Pegelvergleichsstufe V2 ermittelten Pause die Hüllkurvensignalpegel mit den um den Betrag der Offset-Spannung angehobenen Hüllkurvensignalpegeln und außerhalb der Pause die Hüllkurvenpegel mit den um den Betrag der Offset-Spannung angehobenen Integrator-Ausgangspegeln in der dritten Pegelvergleichsstufe verglichen. Hiermit wird eine zusätzliche Stabilisierung der Pausenerkennung und der damit verbundenen Umschaltungen erreicht.

## Patentansprüche

1. Verfahren zur Anpassung der Lautstärke eines mobilen Wiedergabegeräts, insbesondere eines Autoradios, an ein Umgebungsgeräusch, wobei der hinter einem im NF-Signalweg (A-B) angeordneten stellglied (2) anstehende NF-Signalpegel und der Fahrgeräusch-Signalpegel (FG) einer ersten Pegelvergleichsstufe (V1) zugeführt werden, die mit einem Regelglied (1) und dem stellglied (2) einen Regelkreis bildet, der bestrebt ist, die Differenz zwischen dem NF-Signalpegel und dem Fahrgeräusch-Signalpegel zu minimieren, wobei während einer Pause im NF-Signalpegel der Regelkreis (V1, 1, 2) unwirksam geschaltet wird,
dadurch gekennzeichnet,
daß in einer zweiten Pegelvergleichsstufe (V2) der Hüllkurvenpegel (HP) des NF-Signals in vorgegebenen Zeitabständen (Δt) mit einem ständig ansteigenden Ausgangssignal (IP) eines rücksetzbaren Integrators (3) verglichen wird,
daß, solange der Hüllkurvenpegel (HP) zu einem Vergleichszeitpunkt größer als das Integrator-Ausgangssignal (IP) ist, das Integrator-Ausgangssignal (IP) weiter ansteigt und der Regelkreis (V1, 1, 2) wirksam geschaltet ist,
und daß, solange der Hüllkurvenpegel (HP) zu einem Vergleichs zeitpunkt kleiner als das Integrator-Ausgangssignal (IP) ist, also für die Dauer des als NF-Signalpause (T) gewerteten Zeitraumes, das Integrator-Ausgangssignal (IP) auf den momentanen Wert des Hüllkurvenpegels (HP) zurückgesetzt wird, um von dort aus bis zum nächsten Vergleichszeitpunkt anzusteigen, und die Regelschleife (V1, 1, 2) des Regelkreises unwirksam geschaltet wird, während dem stellglied (2) ein den Pegel des NF-Signals beeinflussendes steuersignal zugeführt wird.

2. Verfahren nach Anspruch 1,
dadurch gekennzeichnet,
daß während der Dauer einer NF-Signalpause (T) der NF-Pegel im NF-Signalweg (A-B) langsam abgesenkt wird.

3. Verfahren nach einem der Ansprüche 1 oder 2,
dadurch gekennzeichnet,
daß das dem stellglied (2) während der Dauer einer NF-Signalpause (T) zugeführte externe steuersignal derart beschaffen ist, das es den NF-Signalpegel stetig absenkt.

4. Verfahren nach einem der Ansprüche 1 bis 3,
dadurch gekennzeichnet,
daß die Umschaltung der Regelschleife (V1, 1, 2) über eine dritte Pegelvergleichsstufe (V3) erfolgt, in der der Hüllkurvenpegel (HP) außerhalb einer von der zweiten Pegelvergleichsstufe (V2) ermittelten NF-Signalpause (T) mit einem um einen Offset-Spannungsbetrag angehobenen Integrator-Ausgangssignal (IP) und innerhalb einer ermittelten NF-Signalpause (T) mit einem um den Offset-Spannungsbetrag angehobenen Hüllkurven-Signal (HP) verglichen wird, wobei diese signale der dritten Pegelvergleichsstufe (V3) über ein Additionsglied (5) zugeführt werden, das die signale um den Betrag der Offset-Spannung anhebt.

5. Einrichtung zur Anpassung der Lautstärke eines mobilen Wiedergabegeräts, insbesondere eines Autoradios, an ein Umgebungsgeräusch, wobei der hinter einem im NF-Signalweg (A-B) angeordneten stellglied (2) anstehende NF-Signalpegel und der Fahrgeräusch-Signalpegel (FG) einer ersten Pegelvergleichsstufe (V1) zugeführt werden, die mit einem Regelglied (1) und dem stellglied (2) einen Regelkreis bildet, der bestrebt ist, die Differenz zwischen dem NF-Signalpegel und dem Fahrgeräusch-Signalpegel (FG) zu minimieren,
wobei der Eingang des Regelgliedes (1) über einen elektronisch steuerbaren Umschalter (S1) in einer ersten schaltstellung mit dem Ausgang der ersten Pegelvergleichsstufe (V1) und in einer zweiten schaltstellung mit einer Steuerspannungsquelle verbunden ist,
dadurch gekennzeichnet,
daß eine zweite Pegelvergleichsstufe (V2) zum Vergleich eines Hüllkurvenpegels (HP) des NF-Signals mit einem ständig ansteigenden Ausgangssignal (IP) eines rücksetzbaren Integrators (3) vorgesehen ist, wozu die Eingangsklemme für das NF-Signal über einen Hüllkurvendemodulator (4) mit dem ersten Eingang und der Ausgang des Integrators (3) mit dem zweiten Eingang der zweiten Pegelvergleichsstufe (V2) verbunden ist,
daß der Vergleich von Hüllkurvenpegel (HP) und Integrator-Ausgangssignal (IP) in vorgegebenen Zeitabständen (Δt) erfolgt, wozu der Eingang des Integrators (3) mit einer Impulsquelle verbunden ist,
daß der Ausgang der zweiten Pegelvergleichsstufe (V2) mit dem steuereingang des ersten elektronischen Umschalters (S1) sowie mit einem zur Rücksetzung vorgesehenen steuereingang des Integrators (3) und der Ausgang des Hüllkurvendemodulators (4) mit einem weiteren Eingang des Integrators (3) verbunden ist, so daß solange der Hüllkurvenpegel (HP) zu einem Vergleichszeitpunkt größer als das Integrator-Ausgangssignal (IP) ist, der Regelkreis (V1, 1, 2) wirksam geschaltet ist und das Integrator-Ausgangssignal (IP) weiter ansteigt, während solange der Hüllkurvenpegel (HP) zu einem Vergleichszeitpunkt kleiner als das Integrator-Ausgangssignal (IP) ist, also für die Dauer des als NF-Signalpause (T) gewerteten Zeitraumes, das Integrator-Ausgangssignal (IP) auf den momentanen Wert des Hüllkurvenpegels (HP) zurückgesetzt wird, um von dort aus bis zum nächsten Vergleichszeitpunkt anzusteigen, und die Regelschleife (V1, 1, 2) des Regelkreises unwirksam geschaltet wird, während dem stellglied (2) ein den Pegel des NF-Signals beeinflussendes steuersignal zugeführt wird.

6. Einrichtung zur Anpassung der Lautstärke eines mobilen Wiedergabegeräts, insbesondere eines Autoradios, an ein Umgebungsgeräusch, wobei der hinter einem im NF-Signalweg (A-B) angeordneten stellglied (2) anstehende NF-Signalpegel und der Fahrgeräusch-Signalpegel (FG) einer ersten Pegelvergleichsstufe (V1) zugeführt werden, die mit einem Regelglied (1) und dem stellglied (2) einen Regelkreis bildet, der bestrebt ist, die Differenz zwischen dem NF-Signalpegel und dem Fahrgeräusch-Signalpegel (FG) zu minimieren,
wobei der Eingang des Regelgliedes (1) über einen elektronisch steuerbaren Umschalter (S1) in einer ersten schaltstellung mit dem Ausgang der ersten Pegelvergleichsstufe (V1) und in einer zweiten schaltstellung mit einer Steuerspannungsquelle verbunden ist,
dadurch gekennzeichnet,
daß eine zweite Pegelvergleichsstufe (V2) zum Vergleich eines Hüllkurvenpegels (HP) des NF-Signals mit einem ständig ansteigenden Ausgangssignal (IP) eines rücksetzbaren Integrators (3) vorgesehen ist, wozu die Eingangsklemme für das NF-Signal über einen Hüllkurvendemodulator (4) mit dem ersten Eingang und der Ausgang des Integrators (3) mit dem zweiten Eingang der zweiten Pegelvergleichsstufe (V2) verbunden ist,
daß der Vergleich von Hüllkurvenpegel (HP) und Ausgangssignal (IP) des Integrators (IP) in vorgegebenen Zeitabständen (Δt) erfolgt, wozu der Eingang des Integrators (3) mit einer Impulsquelle verbunden ist,
daß der Ausgang der zweiten Pegelvergleichsstufe (V2) mit einem zur Rücksetzung vorgesehenen steuereingang des Integrators (3) und der Ausgang des Hüllkurvendemodulators (4) mit einem weiteren Eingang des Integrators (3) verbunden ist, so daß solange der Hüllkurvenpegel (HP) zu einem Vergleichs zeitpunkt größer als das Integrator-Ausgangssignal (IP) ist, das Integrator-Ausgangssignal (IP) weiter ansteigt, während solange der Hüllkurvenpegel (HP) zu einem Vergleichszeitpunkt kleiner als das Integrator-Ausgangssignal (IP) ist, also für die Dauer des als NF-Signalpause (T) gewerteten Zeitraumes, das Integrator-Ausgangssignal (IP) auf den momentanen Wert des Hüllkurvenpegels (HP) zurückgesetzt wird, um von dort aus bis zum nächsten Vergleichszeitpunkt anzusteigen,
daß zur Ansteuerung des ersten Umschalters (S1) und damit zur Umschaltung der Regelschleife (V1, 1, 2) eine dritte Vergleichsstufe (V3) vorgesehen ist, in der der Hüllkurvenpegel (HP) außerhalb einer mittels der zweiten Pegelvergleichsstufe (V2) ermittelten NF-Signalpause (T) mit dem um einen Offset-Spannungsbetrag angehobenen Integrator-Ausgangssignal (IP) und innerhalb einer ermittelten NF-Signalpause (T) mit einem um den Offset-Spannungsbetrag angehobenen Hüllkurven-Signal (HP) verglichen wird,
wozu der Ausgang der zweiten Pegelvergleichsstufe (V2) mit dem steuereingang eines zweiten elektronischen Umschalters (S2) verbunden ist,
und wozu der erste Eingang der dritten Pegelvergleichsstufe (V3) mit dem Ausgang des Hüllkurvendemodulators (4) und der zweite Eingang der dritten Pegelvergleichsstufe (V3) mit dem Ausgang eines Addiergliedes (5) verbunden ist,
wobei ein Eingang des Addiergliedes (5) über den zweiten elektronischen schalter (S2) bei erkannter NF-Signalpause (T) mit dem Ausgang des Hüllkurvendemodulators (4) und außerhalb einer ermittelten NF-Signalpause (T) mit dem des Integrators (3) verbunden, dem anderen Eingang des Addiergliedes (5) der Offset-Spannungswert zugeführt ist.

## Claims

1. Method for adapting the loudness level of a mobile reproduction unit, in particular a car radio, to an ambient noise level, the AF signal level downstream of an actuator (2) arranged in the AF signal path (A-B) and the driving-noise signal level (FG) being fed to a first level-comparison stage (V1), which, together with a regulating element (1) and the actuator (2), forms a regulating circuit which aims to minimize the difference between the AF signal level and the driving-noise signal level, the regulating circuit (V1, 1, 2) being deactivated during a pause in the AF signal level,
characterized
in that, in a second level-comparison stage (v2), the envelope level (HP) of the AF signal is compared at predetermined time intervals (Δt) with a continually rising output signal (IP) of a resettable integrator (3),
in that, as long as the envelope level (HP) is higher than the integrator output signal (IP) at a comparison instant, the integrator output signal (IP) continues to rise and the regulating circuit (V1, 1, 2) is activated,
and in that, as long as the envelope level (HP) is lower than the integrator output signal (IP) at a comparison instant, that is to say for the duration of the time period assessed as AF signal pause (T), the integrator output signal (IP) is reset to the instantaneous value of the envelope level (HP) in order to rise from that point until the next comparison instant, and the regulating loop (V1, 1, 2) of the regulating circuit is deactivated, while a control signal influencing the level of the AF signal is fed to the actuator (2).

2. Method according to Claim 1,
characterized
in that the AF level in the AF signal path (A-B) is slowly reduced for the duration of an AF signal pause (T).

3. Method according to either of Claims 1 and 2,
characterized
in that the external control signal fed to the actuator (2) for the duration of an AF signal pause (T) is such that it steadily reduces the AF signal level.

4. Method according to one of Claims 1 to 3,
characterized
in that the changeover of the regulating loop (V1, 1, 2) is effected via a third level-comparison stage (V3), in which the envelope level (HP) is compared, during the time not occupied by an AF signal pause (T) determined by the second level-comparison stage (V2), with an integrator output signal (IP) increased by the magnitude of an offset voltage and is compared, during the time occupied by an AF signal pause (T) that has been determined, with an envelope signal (HP) increased by the magnitude of the offset voltage, these signals being fed to the third level-comparison stage (V3) via an addition element (5), which increases the signals by the magnitude of the offset voltage.

5. Device for adapting the loudness level of a mobile reproduction unit, in particular a car radio, to an ambient noise level, the AF signal level downstream of an actuator (2) arranged in the AF signal path (A-B) and the driving-noise signal level (FG) being fed to a first level-comparison stage (V1), which, together with a regulating element (1) and the actuator (2), forms a regulating circuit which aims to minimize the difference between the AF signal level and the driving-noise signal level (FG),
the input of the regulating element (1) being connected, via an electronically controllable changeover switch (S1), to the output of the first level-comparison stage (V1) when the said changeover switch is in a first switch position, and to a control voltage source when the said changeover switch is in a second switch position,
characterized
in that provision is made of a second level-comparison stage (V2) for comparing an envelope level (HP) of the AF signal with a continually rising output signal (IP) of a resettable integrator (3), for which purpose the input terminal for the AF signal is connected to the first input of the second level-comparison stage (V2) via an envelope demodulator (4) and the output of the integrator (3) is connected to the second input of the said second level-comparison stage (V2),
in that the envelope level (HP) and the integrator output signal (IP) are compared at predetermined time intervals (At), for which purpose the input of the integrator (3) is connected to a pulse source,
in that the output of the second level-comparison stage (V2) is connected to the control input of the first electronic changeover switch (S1) and also to a control input, provided for resetting, of the integrator (3) and the output of the envelope demodulator (4) is connected to a further input of the integrator (3), with the result that, as long as the envelope level (HP) is higher than the integrator output signal (IP) at a comparison instant, the regulating circuit (V1, 1, 2) is activated and the integrator output signal (IP) continues to rise, while as long as the envelope level (HP) is lower than the integrator output signal (IP) at a comparison instant, that is to say for the duration of the time period assessed as AF signal pause (T), the integrator output signal (IP) is reset to the instantaneous value of the envelope level (HP) in order to rise from that point until the next comparison instant, and the regulating loop (V1, 1, 2) of the regulating circuit is deactivated, while a control signal influencing the level of the AF signal is fed to the actuator (2).

6. Device for adapting the loudness level of a mobile reproduction unit, in particular a car radio, to an ambient noise level, the AF signal level downstream of an actuator (2) arranged in the AF signal path (A-B) and the driving-noise signal level (FG) being fed to a first level-comparison stage (V1), which, together with a regulating element (1) and the actuator (2), forms a regulating circuit which aims to minimize the difference between the AF signal level and the driving-noise signal level (FG),
the input of the regulating element (1) being connected, via an electronically controllable changeover switch (S1), to the output of the first level-comparison stage (V1) when the said changeover switch is in a first switch position, and to a control voltage source when the said changeover switch is in a second switch position,
characterized
in that provision is made of a second level-comparison stage (V2) for comparing an envelope level (HP) of the AF signal with a continually rising output signal (IP) of a resettable integrator (3), for which purpose the input terminal for the AF signal is connected to the first input of the second level-comparison stage (V2) via an envelope demodulator (4) and the output of the integrator (3) is connected to the second input of the said second level-comparison stage (V2),
in that the envelope level (HP) and the integrator output signal (IP) are compared at predetermined time intervals (Δt), for which purpose the input of the integrator (3) is connected to a pulse source,
in that the output of the second level-comparison stage (V2) is connected to a control input, provided for resetting, of the integrator (3) and the output of the envelope demodulator (4) is connected to a further input of the integrator (3), with the result that, as long as the envelope level (HP) is higher than the integrator output signal (IP) at a comparison instant, the integrator output signal (IP) continues to rise, while as long as the envelope level (HP) is lower than the integrator output signal (IP) at a comparison instant, that is to say for the duration of the time period assessed as AF signal pause (T), the integrator output signal (IP) is reset to the instantaneous value of the envelope level (HP) in order to rise from that point until the next comparison instant,
in that, in order to drive the first changeover switch (S1) and thus in order to change over the regulating loop (V1, 1, 2), provision is made of a third comparison stage (V3), in which the envelope level (HP) is compared, during the time not occupied by an AF signal pause (T) determined by means of the second level-comparison stage (V2), with the integrator output signal (IP) increased by the magnitude of an offset voltage and is compared, during the time occupied by an AF signal pause (T) that has been determined, with an envelope signal (HP) increased by the magnitude of the offset voltage,
for which purpose the output of the second level-comparison stage (V2) is connected to the control input of a second electronic changeover switch (S2),
and for which purpose the first input of the third level-comparison stage (V3) is connected to the output of the envelope demodulator (4) and the second input of the third level comparison stage (V3) is connected to the output of an addition element (5),
one input of the addition element (5) being connected, via the second electronic switch (S2), to the output of the envelope demodulator (4) in the event of an AF signal pause (T) having been identified, and to the output of the integrator (3) during the time not occupied by an AF signal pause (T) that has been determined, and the offset voltage value being fed to the other input of the addition element (5).

## Revendications

1. Procédé d'adaptation du volume sonore d'un appareil de reproduction sonore mobile notamment d'un autoradio, en fonction du bruit ambiant, selon lequel en aval d'un actionneur (2) monté dans le chemin signal BF (A-B) pour le niveau de signal BF appliqué et le niveau de signal de bruit de circuit FG, sont appliqués à un premier comparateur de niveau (V1) qui forme un circuit de régulation avec un organe de régulation (1) et un actionneur (2), ce circuit ayant tendance à minimiser la différence entre le niveau du signal BF et le niveau du signal de bruit de circulation, et pendant une pause du niveau du signal BF, on neutralise le circuit de régulation (V1, 1, 2),
caractérisé en ce que
• dans un second comparateur de niveau (V2), on compare le niveau de la courbe enveloppe (HP) du signal BF à des intervalles de temps prédéterminés (Δt) avec un signal de sortie (IP) croissant en continu d'un intégrateur (3) susceptible d'être remis à l'état initial, et
• aussi longtemps que le niveau de la courbe enveloppe (HP) à un instant de comparaison est supérieur au signal de sortie de l'intégrateur (IP), le signal de sortie de l'intégrateur (IP) continue d'augmenter et le circuit de régulation (V1, 1, 2) est neutralisé, et
• aussi longtemps que le niveau de la courbe enveloppe (HP) à un instant de comparaison est inférieur au signal de sortie (IP) de l'intégrateur, c'est-à-dire pendant la durée de l'intervalle exploité comme pause du signal BF (T), le signal de sortie (IP) de l'intégrateur est remis à la valeur instantanée du niveau de la courbe enveloppe (HP), pour remonter à partir delà jusqu'à l'instant de comparaison suivant, et la boucle de régulation (V1, 1, 2) du circuit de régulation est neutralisée pendant que l'actionneur (2) fournit un signal de commande influençant le niveau du signal BF.

2. Procédé selon la revendication 1,
caractérisé en ce que
pendant la durée d'une pause de signal BF (T), on abaisse lentement le niveau BF dans la branche de signal BF (A-B).

3. Procédé selon l'une des revendications 1 ou 2,
caractérisé en ce que
le signal de commande externe appliqué à l'actionneur (2) pendant la durée d'une pause de signal BF (T) est tel que ce signal abaisse en permanence le niveau du signal BF.

4. Procédé selon l'une quelconque des revendications 1 à 3,
caractérisé en ce que
la commutation de la boucle de régulation (V1, 1, 2) se fait par un troisième comparateur de niveau (3) qui compare le niveau de la courbe enveloppe (HP) en dehors d'une pause de signal BF (T) déterminé par le second comparateur de niveau (V2), avec un signal de sortie de l'intégrateur (IP) augmenté d'une valeur de tension de décalage, et à l'intérieur de la pause de signal BF (T) obtenue, on compare avec un signal de courbe enveloppe (HP) relevé de la valeur de la tension de décalage, et ces signaux sont appliqués à une troisième boucle de comparaison de niveau (V3) par un additionneur (5) qui relève les signaux de la valeur de la tension de décalage.

5. Installation d'adaptation du volume sonore d'un appareil de reproduction sonore mobile notamment d'un autoradio aux bruits ambiants, le niveau de signal BF disponible en aval d'un actionneur (2) de la branche de signal BF (A-B) et le niveau de signal de bruit de circulation (FG) sont fournis à un premier comparateur de niveau (V1) qui forme un circuit de régulation avec un organe de régulation (1) et l'actionneur (2), celui-ci ayant tendance à minimiser la différence entre le niveau de signal BF et le niveau de signal de bruit de circulation (FG), l'entrée de l'organe de régulation (1) étant reliée par un commutateur à commande électronique (S1) dans une première position de commutation, avec la sortie du premier comparateur de niveau (V1) et dans une seconde position de commutation, avec une source de tension de commande,
caractérisée en ce que
• pour un second comparateur de niveau (V2) pour comparer un niveau de courbe enveloppe (HP) du signal BF avec un signal de sortie (IP), croissant en permanence, fourni par un intégrateur (3) susceptible d'être remis à l'état initial, et la borne d'entrée du signal BF est reliée par un démodulateur de courbe enveloppe (4) à la première entrée et la sortie de l'intégrateur (3) est reliée à la seconde entrée du second comparateur de niveau (V2),
• la comparaison du niveau de courbe enveloppe (HP) et du signal de sortie d'intégrateur (IP) étant faite dans des intervalles de temps prédéterminés (Δt) et pour cela l'entrée de l'intégrateur (3) est reliée à une source d'impulsions,
• la sortie du second comparateur de niveau (V2) étant reliée à l'entrée de commande du premier commutateur électronique (S1) ainsi qu'à une entrée de commande de l'intégrateur (3) prévue pour la remise à l'état initial, et la sortie du démodulateur de courbe enveloppe (4) reliée à une autre entrée de l'intégrateur (3) pour qu'aussi longtemps que le niveau de courbe enveloppe (HP) à un instant de comparaison est supérieur au signal de sortie de l'intégrateur (IP), le circuit de régulation (V1, 1, 2) est actif et le signal de sortie (IP) de l'intégrateur continue d'augmenter alors qu'aussi longtemps que le niveau de la courbe enveloppe (HP) à un instant de comparaison est inférieur au signal de sortie de l'intégrateur (IP), c'est-à-dire pour une durée d'un intervalle de temps exploité comme pause de signal BF (T), le signal de sortie (IP) de l'intégrateur est remis à la valeur instantanée du niveau de courbe enveloppe (HP), pour augmenter de nouveau à partir delà jusqu'au point de comparaison suivant et la boucle de régulation (V1, 1, 2) du circuit de régulation est neutralisée alors que l'actionneur (2) reçoit un signal de commande influençant le niveau du signal BF.

6. Installation pour adapter le volume sonore d'un appareil de reproduction sonore mobile notamment d'un autoradio selon les bruits ambiants, selon lequel le niveau du signal BF pris en aval de l'actionnement (2) monté dans la branche de signal BF (A-B) et le niveau de signal de bruit de circulation (FG) sont appliqués à un premier comparateur de niveau (V1) qui forme un circuit de régulation avec un organe de régulation (1) et avec l'actionneur (2), ce circuit ayant tendance à minimiser la différence entre le niveau du signal BF et le niveau du signal de bruit de roulement (FG) ; l'entrée de l'organe de régulation (1) étant reliée par un commutateur à commande électronique (S1) occupant une première position de commutation, à la sortie du premier comparateur de niveau (V1) et dans une seconde position de commutation, avec une source de tension de commande,
caractérisée en ce qu'
• un second comparateur de niveau (V2) compare un niveau de courbe enveloppe (HP) du signal BF à un signal de sortie (IP) augmentant en continu, fourni par un intégrateur (3) susceptible d'être remise à l'état initial, et la borne d'entrée du signal BF est reliée par un démodulateur de courbe enveloppe (4) à la première entrée et la sortie de l'intégrateur (3) est reliée à la seconde entrée du second comparateur de niveau (V2),
• la comparaison du niveau de courbe enveloppe (HP) et du signal de sortie (IP) de l'intégrateur (IP) se faisant dans des intervalles de temps prédéterminés (Δt), et pour cela l'entrée de l'intégrateur (3) est reliée à une source d'impulsions,
• la sortie du second comparateur de niveau (V2) est reliée à une entrée de commande de l'intégrateur (3) prévue pour la remise à l'état initial et la sortie du démodulateur de courbe enveloppe (4) est reliée à une autre entrée de l'intégrateur (3), de sorte qu'aussi longtemps que le niveau de la courbe enveloppe (HP) à un instant de comparaison est supérieur au signal de sortie de l'intégrateur (IP), ce signal de sortie de l'intégrateur (IP) continue d'augmenter, alors qu'aussi longtemps que le niveau de la courbe enveloppe (HP) à un instant de comparaison est inférieur au signal de sortie de l'intégrateur (IP), c'est-à-dire pour la durée de l'intervalle de temps exploité comme pause de signal BF (T), le signal de sortie de l'intégrateur (IP) est remis à la valeur instantanée du niveau de la courbe enveloppe (HP), pour augmenter de nouveau à partir delà jusqu'au point de comparaison suivant,
• pour commander le premier commutateur (S1) et ainsi commuter la boucle de régulation (V1, 1, 2), un troisième comparateur (V3) compare le niveau de courbe enveloppe (HP) en dehors d'une pause de signal BF (T) déterminée par le second comparateur de niveau (V2), avec le signal de sortie (IP) de l'intégrateur, relevé de la valeur de la tension de décalage, et à l'intérieur d'une pause de signal BF (T), obtenue, on compare avec un signal de courbe enveloppe (HP) relevé de la valeur de la tension de décalage,
• et la sortie du second comparateur de niveau (V2) est pour cela reliée à l'entrée de commande d'un second commutateur électronique (S2),
• et la première entrée du troisième comparateur de niveau (v3) est reliée à la sortie du démodulateur de courbe enveloppe (4) et la seconde entrée du troisième comparateur de niveau (V3) est reliée à la sortie d'un additionneur (5),
• une entrée de l'additionneur (5) étant reliée par le second commutateur électronique (S2) lorsqu'une pause de signal BF (T) est reconnue, à la sortie du démodulateur de courbe enveloppe (4) et en dehors d'une pause de signal BF, (T), déterminée, la liaison est faite avec l'intégrateur (3) et l'autre entrée de l'additionneur (5) recevant la tension de décalage.
